# EUROPÄISCHE PATENTANMELDUNG

(11) **EP 2 071 727 A1**
(43) Veröffentlichungstag der Anmeldung: **17.06.2009**
(21) Anmeldenummer: 08021506.4
(22) Anmeldetag: 11.12.2008
(51) Int. Cl.: H03K 17/96

(54) **Berührungsempfindlicher Tastschalter**

(30) Priorität: 12.12.2007 DE 102007060293
(71) Anmelder: Diehl AKO Stiftung & Co. KG, 88239 Wangen (DE)
(72) Erfinder: Arnold, Georg, 91126 Schwabach (DE); Wolf, Johann, 90768 Fürth (DE)
(74) Vertreter: Diehl Patentabteilung

(57) **Zusammenfassung**

Berührungsempfindlicher Tastschalter (10), mit einem Infrarot-Strahlung aussendenden Sender (12) und einem Infrarot-Strahlung empfangenden Empfänger (14), und mit wenigstens einem sichtbares Licht aussenden Signalelement (16), wobei Sender (12), Empfänger (14) und Signalelement (16) in ein einziges Lichtleitelement (18) einstrahlen, wobei infolge optischer Strahlführung eine Trennung des Sende- (20) und des Empfangskanals (22) im Lichtleitelement (18) derart erfolgt, dass sich an der dem Sender (12) und dem Empfänger (14) abgewandten oberseitigen Fläche (24) des Lichtleitelements (18) nur auf einem geringen Anteil der Fläche eine Überlagerung (26) des vom Sender (12) bestrahlbaren und des vom Empfänger (14) detektierbaren Bereichs ergibt.

## Beschreibung

Die vorliegende Erfindung betrifft einen berührungsempfindlichen Tastschalter nach dem Oberbegriff des Anspruchs 1 und insbesondere einen solchen Tastschalter zur Verwendung in einer Bedienungseinrichtung eines Haushaltsgerätes.

Der grundsätzliche Aufbau und das Grundprinzip eines solchen berührungsempfindlichen Tastschalters sind z. B. aus der DE 40 07 971 A1 bekannt. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Eine vorteilhafte Anwendung derartiger berührungsempfindlicher Tastschalter ist z. B. der Einsatz in Bedieneinrichtungen von Haushaltsgeräten wie Kochherden, Glaskeramikkochfeldem, Mikrowellenherden und dergleichen, bei denen der Tastschalter, damit er einfach zu bedienen und das Gerät auch zu reinigen ist, hinter einer Abdeckung, wie beispielsweise einer Glasplatte oder Glaskeramikplatte untergebracht ist.

Ferner beschreibt das deutsche Gebrauchsmuster DE 202 15 326 U1 der Anmelderin einen berührungsempfindlichen Tastschalter, der zusätzlich eine Signalisierungsleuchte aufweist, welche dem Benutzer z. B. die Betriebsbereitschaft oder die erfolgte Bedienung des Tastschalters anzeigen kann.

Aus der DE 10 2004 025 878 B4 ist ein berührungsempfindlicher Tastschalter bekannt, der zwei Lichtteitetemente aufweist. Diese Lichtleitelemente leiten Infrarotstrahlung vom Sender zur Reflexionsfläche und weiter zum Empfänger. Zusätzlich wird von einem Signalelement ausgehend sichtbares Licht in beide Lichtleitelemente eingekoppelt und der Tastschalter beleuchtet. Da pro Tastschalter zwei beleuchtete Felder vorliegen und zwischen den beiden Lichtieltelementen eine Trennlinie sichtbar ist, ist das ästhetische Empfinden des Bedieners gestört und der Bediener irrifiert.

Aus der DE 198 51 505 A1 ist eine nur ein einziges Lichtleitelement aufweisende Signalisierungsteuchte bekannt. In das Lichtleitelement wird sowohl sichtbares als auch Infrarotlicht eingestrahlt. Nachteilig an dieser Ausgestaltung ist jedoch, dass einerseits nur ein sehr kleines Feld mit sichtbarem Licht beleuchtet ist und andererseits auch durch infrarote Störstrahlung, wie beispielsweise fehlgeleitete Reflexionen, Schaltvorgänge ausgelöst werden können und somit das Schaltverhalten unsicher ist.

In Erkenntnis dieser Gegebenheiten liegt vorliegender Erfindung deshalb die Problemstellung zugrunde, einen berührungsempfindlichen Tastschalter und eine Bedieneinrichtung mit einem solchen Tastschalter bereitzustellen, der einerseits eine einzige durchgängig beleuchtete Bedienfläche aufweist und andererseits ein sicheres Schaltverhalten gewährleistet, das nicht durch Störsignale auslösbar ist.

Die erstgenannte Aufgabe wird erfindungsgemäß gelöst durch einen Berührungsempfindlichen Tastschalter, mit einem Infrarot-Strahlung aussendenden Sender und einem Infrarot-Strahlung empfangenden Empfänger, und mit wenigstens einem sichtbares Licht aussenden Signalelement, wobei Sender, Empfänger und Signalelement in ein einziges Lichtleitelement einstrahlen, wobei infolge optischer Strahlführung eine Trennung des Sende- und des Empfangskanals im Lichtleitelement derart erfolgt, dass sich an der dem Sender und dem Empfänger abgewandten oberseitigen Fläche des Lichtleitelements nur auf einem geringen Anteil der Fläche eine Überlagerung des vom Sender bestrahlbaren und des vom Empfänger detektierbaren Bereichs ergibt.

Mit anderen Worten weist der berührungsempfindliche Tastschalter ein einziges Lichtleitelement auf, in das einerseits von einem Signalelement ausgesandtes sichtbares Licht eingestrahlt wird und andererseits von einem Sender ausgesandte Infrarotstrahlung eingekoppelt wird, deren reflektierte Anteile im Lichtleitelement zum Infrarotstrahlung empfangenden Empfänger geleitet wird. Zur Vermeidung von Störsignalen weist das Lichtleiterelement in Folge optischer Strahlführung eine Trennung des Sende- und des Empfangskanals auf. Durch die Auftrennung des Sende- und Empfangskanals im Lichtleitelement ergibt sich auf der dem Sender und dem Empfänger abgewandten oberseitigen Fläche des Lichtleitelements auf nur einem geringen Flächenanteil eine Überlagerung von Sende- und Empfangskanal.

In einer vorteilhaften Weiterbildung ist das Mittel zur optischen Strahlführung für Sender, Empfänger und Signalelement durch jeweils eine runde oder eckige Säule, die an der dem Sender, Empfänger und Signalelement zugewandten unterseitigen Fläche des Lichtleitelements ausgebildet ist.

An der unterseitigen Fläche des Lichtleitelements, die dem Sender, Empfänger und Signalelement zugewandt sind, sind Mittel zur optischen Strahlführung vorgesehen. Die Mittel zur optischen Strahlführung sind jeweils eine Säule, die dem Sender, dem Empfänger und dem Signalelement zugeordnet ist, wobei die Säulen rund oder eckig ausgestaltet sind.

In einer bevorzugten Alternative ist das Mittel zur optischen Strahlführung im Lichtleitelement integriert. Durch diese Maßnahme ergibt sich ein besonders robustes Lichtleitelement. Das Mittel zur optischen Strahlführung kann einerseits vom Lichtleitelement umschlossen sein und andererseits auf das Lichtleitelement aufgesetzt sein. Besonders vorteilhaft zur Vereinfachung des Montageaufwandes und zur Reduzierung der Kosten sind Lichtleitelement und Mittel zur optischen Strahlführung als ein Bauteil ausgeführt.

In einer weiteren Ausführungsform ist das Mittel zur optischen Strahlführung im Lichtleitelement durch eine im Lichtleitelement ringförmig um die Einkoppelflächen des Signalelements verlaufende Nut oder durch eine gerade oder gebogen verlaufene Nut zwischen den Einkoppelflächen von Sender und Signalelement sowie durch eine gerade oder gebogen verlaufene Nut zwischen den Einkoppelflächen von Signalelement und Empfänger gebildet.

Das Mittel zur optischen Strahlführung im Lichtleitelement kann die Einkoppelfläche des Signalelements in Form einer ringförmigen Nut umschließen. Besonders vorteilhaft an dieser Ausgestaltung ist, die Abschirmung der Einkoppelfläche des Signalelements vor Infrarotstrahlung. Alternativ kann zwischen den Einkoppelflächen von Sender und Signalelement eine Nut verlaufen, die gerade oder gebogen ausgestaltet ist. Zusätzlich zu dieser ersten Nut kann eine zweite gerade oder gebogen verlaufende Nut zwischen den Einkoppelflächen von Signalelement und Empfänger im Lichtleitelement vorhanden sein. Besonders vorteilhaft an der unterschiedlichen Ausgestaltung der Nut ist die Möglichkeit der Einflussnahme auf die optische Strahlführung.

Vorteilhafterweise verläuft die von der Mittelsenkrechten des Lichtleitelements abgewandte Seite der Nut zur Mittelsenkrechten hin geneigt. Besonders vorteilhaft an der Neigung der Seite der Nut, die von der Mittelsenkrechten des Lichtleitelements abgewandt ist, dass die laterale Ausbreitung des Sende- bzw. des Empfangskanals im Lichtleitelement durch den Neigungswinkel einstellbar ist.

Zweckmäßigerweise verläuft die der Mittelsenkrechten des Lichtleitelements zugewandte Seite der Nut von der Mittelsenkrechten weg geneigt. Durch die Neigung der Mittelsenkrechten des Lichtleitelements zugewandten Seite der Nut von der Mittelsenkrechten weg, wird gewährleistet, dass die laterale Ausbreitung des sichtbaren Lichts im Lichtleitelement und damit das Ausmaß der durch sichtbares Licht beleuchteten Fläche des Lichtleitelements einstellbar ist.

In einer weiteren Ausgestaltung erfolgt die optische Strahlführung außerhalb des Lichtleitelements durch eine Anordnung von Sender, Empfänger und Signalelement mit unterschiedlichem Abstand zum Lichtleitelement. In vorteilhafter Weise lassen sich durch unterschiedliche Abstände von Sender, Empfänger und Signalelement zum Lichtleitelement unterschiedliche Durchmesser der Strahlkeulen einstellen und dadurch die Trennung von Sende- und Empfangskanal sowie der beleuchtete Anteil des Lichtleitelements bewirken.

Vorteilhafterweise weist das Lichtleitelement einen eckigen oder einen runden Querschnitt auf und verläuft zwischen der unterseitigen und der oberseitigen Fläche keilförmig oder konisch. Bei rundem oder eckigem Querschnitt des Lichtleitelements wird durch eine konische oder keilförmige Ausgestaltung zwischen der unterseitigen und der oberseitigen Fläche des Lichtleitelements sichergestellt, dass eine homogene Strahlungsverteilung von Infrarot und sichtbarem Licht im Lichtleitelement vorliegt. Darüber hinaus lassen sich konische oder keilförmige Lichtleitelemente besonders einfach montieren und sind reversibel in einem entsprechend angepassten Halterahmen fixiert.

In einer besonders vorteilhaften Weiterbildung beiträgt der Anteil der Fläche des Lichtleitelements, auf dem die Überlagerung des vom Sender bestrahlbaren und des vom Empfänger detektierbaren Bereichs möglich ist, zwischen 0 bis maximal 40 % und liegt bevorzugt zwischen 0 bis maximal 20 %.

Besonders vorteilhaft ist es, wenn die Überlagerung von Sende- und Empfangskanal in Bezug auf den Anteil der Fläche des Lichtleitelements zwischen 0 bis maximal 40 % beträgt. Hierdurch wird vermieden, dass Störsignale als Schaltereignisse detektiert werden. Zusätzlich hierzu wird das Signalrauschverhältnis optimiert, wenn der überlagerte Anteil der Fläche des Lichtleitelements zwischen 0 bis maximal 20 % liegt. Optimal ist ein Anteil der Fläche des Lichtleitelements auf dem die Überlagerung von Sende- und Empfangskanal vorliegt, wenn dieser Anteil zwischen 0 bis maximal 10 % beträgt.

Eine zweite Aufgabe hinsichtlich einer Vorrichtung wird erfindungsgemäß gelöst durch eine Bedieneinrichtung für ein Haushaltsgerät mit wenigstens einem berührungsempfindlichen Tastschalter nach einem der Ansprüche 1 bis 9.

Besonders vorteilhaft ist der berührungsempfindliche Tastschalter hinter einer für elektromagnetische Strahlung zumindest teildurchlässigen Abdeckung angeordnet, wobei die Abdeckung in eine Bedienblende integriert ist. Hierdurch ist der Tastschalter vor Verschmutzung und mechanischer Beschädigung geschützt. Das einzige Lichtleitelement ist durch eine Halterung so über einer Platine gehaltert, dass Sender, Empfänger und Lichtsignalelement in das Lichtleitelement einstrahlen können. Das Lichtleitelement kann in der Halterung durch Klemmen, Einlegen, mittels Federkraft oder Kleben reversibel bzw. dauerhaft gehaltert sein. Hierdurch ist einerseits eine flexiblere Montage bzw. ein besseres Handling gewährleistet, andererseits kann dadurch auf konstruktive Erfordernisse reagiert werden.

Mehrere Ausführungsbeispiele werden anhand der Zeichnung und anhand einer nachstehenden Beschreibung näher erläutert. Es zeigen
- Figur 1: eine schematische Darstellung eines gehalterten ersten Lichtleitelements im Querschnitt,
- Figur 2: eine schematische Darstellung eines gehalterten ersten Lichtleitelements im Querschnitt, wobei die Ansicht gegenüber Figur 1 um 90° gedreht ist,
- Figur 3: schematisch die Trennung von Sende- und Empfangskanal in einem Lichtleitelement,
- Figur 4: eine schematische Darstellung eines zweiten Lichtleitelements und
- Figur 5: eine schematische Darstellung eines dritten Lichtleitelements.
Identische Bezugszeichen bezeichnen in alle Figuren identische Komponenten.

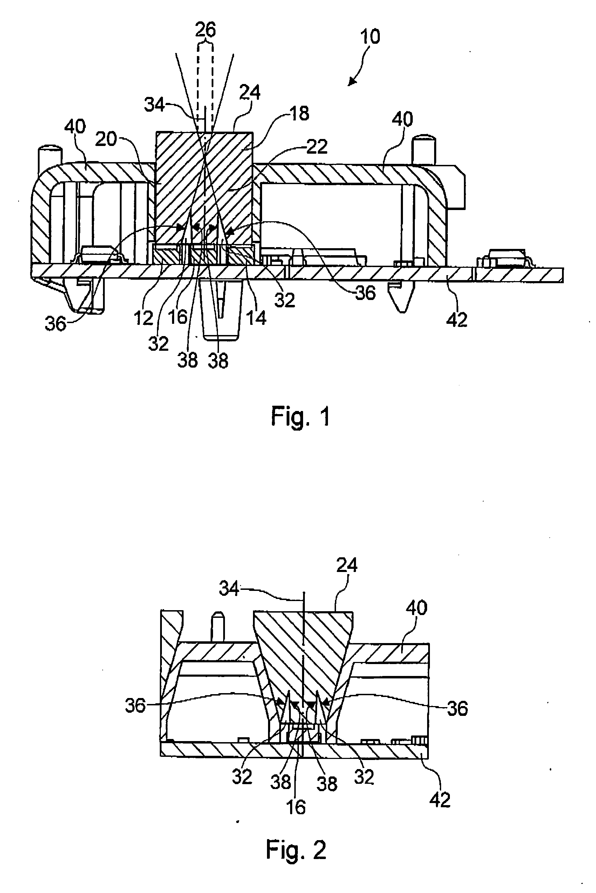

Figur 1 zeigt in Form eines schematischen Querschnitts ein in einer Halterung 40 über einer Platine 42 gehaltertes Lichtleitelement 18. Neben weiteren elektronischen Bauteilen trägt die Platine 42, in Form von SMD-Bauteilen, einen Sender 12, ein Signalelement 16 und einen Empfänger 14. Der Sender 12 strahlt über eine Einkoppelfläche des Lichtleitelements 18 Infrarotstrahlung in das Lichtleitelement 18 ein, die über eine Auskoppelfläche des Lichtleitelements 18 zum Empfänger 14 reflektiert wird. Das Signalelement 16, beispielsweise eine LED, strahlt sichtbares Licht in das Lichtleitelement 18 ein.

In diesem ersten Ausführungsbeispiel bildet eine ringförmige Nut 32 um die Einkoppelfläche des Signalelements 16 im Lichtleitelement 18 das Mittel zur optischen Strahlführung. Die der Mittelsenkrechten 34 des Lichtleitelements 18 abgewandten Seite 36 der Nut 32 ist zur Mittelsenkrechten 34 hin geneigt. Durch die Neigung der Nutseite 36 wird eine Trennung des Sendekanals 20 von dem Empfangskanal 22 erzielt. Durch den Neigungswinkel der Nutseite 36 ist die Ausbreitung des Sende- 20 und Empfangskanals 22 in die Richtung der Mittelsenkrechten 34 festgelegt. Je flacher der Neigungswinkel der Nutseite 36 ausgebildet ist, desto größer ist der Bereich, in dem eine Überlagerung 26 des Sende- 20 und Empfangskanals 22 auf der dem Sender 12 und Empfänger 14 abgewandten oberseitigen Fläche 24 des Lichtleitelements 18 vorliegt.

Alternativ oder zusätzlich zu der, der Mittelsenkrechten 34 abgewandten Nutseite 36, kann die der Mittelsenkrechten 34 zugewandte Nutseite 38 geneigt ausgestaltet sein. Die Neigung der Nutseite 38 ist dabei bevorzugt von der Mittelsenkrechten 34 weggeneigt, so dass die laterale Ausbreitung des eingekoppelten sichtbaren Lichts vom Signalelement 16 vorgegeben ist.

Sowohl die ringförmige Nut 32 als auch die gerade oder gebogen verlaufende Nuten 46 können einseitig geneigt oder beidseitig geneigt ausgebildet sein, also eine V-Form aufweisen.

Die Halterung 40 kann auf unterschiedliche Weise ausgestaltet sein. So kann die Halterung 40 der äußeren Form des Lichtleitelements 18 angepasst sein, so dass das Lichtleitelement 18 in der Halterung 40 verklemmt und dadurch fixiert ist. Das Verklemmen ermöglicht einerseits eine einfache Montage, da das Lichtleitelement 18 fixiert ist, andererseits handelt es sich bei dieser Art der Fixierung um eine reversible Fixierung. Weitere reversible Befestigungsmöglichkeiten sind einfaches Einlegen in die Halterung 40 oder Verspannen mittels Federn. Eine starre Fixierung des Lichtleitelements 18 kann durch Verkleben erfolgen.

Figur 2 zeigt einen im Vergleich zu Figur 1 um 90° gedrehten schematischen Querschnitt durch einen berührungsempfindlichen Tastschalter 10. Entsprechend den in Figur 1 beschriebenen Elementen zeigt Figur 2 ein eckiges Lichtleitelement 18, dass zwischen seiner unterseitigen und seiner oberseitigen Fläche 30, 24 keilförmig verläuft und durch die Halterung 40 mittels Verklemmen gehaltert ist.

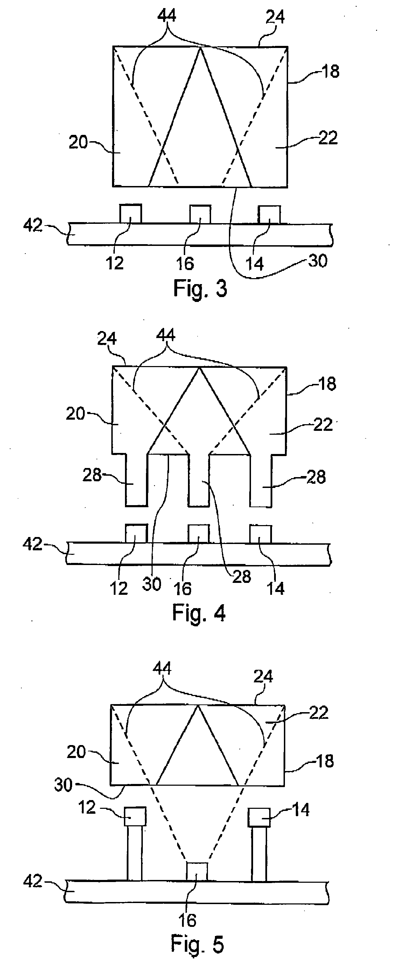

Figur 3 zeigt schematisch ein eckiges Lichtleitelement 18, in dem der sich vom Sender 12 erstreckende Sendekanal 20 und der zum Empfänger 14 erstreckende Empfangskanal 22 zwischen der unterseitigen Fläche 30 und der oberseitigen Fläche 24 des Lichtleitelements 18 angedeutet ist. Im dargestellten Beispielsfall ist der Anteil der Fläche des Lichtleitelements 18, auf dem eine Überlagerung 26 des Sende- 20 und des Empfangskanals 22 vorliegt, 0 %. Sende- 20 und Empfangskanal 22 sind also vollständig voneinander entkoppelt. Zusätzlich zu Sende- 20 und Empfangskanal 22 ist der vom Signalelement 16 durch sichtbares Licht gebildete Beleuchtungskegel 44 mit gestrichelten Linien angedeutet. In dieser Ausgestaltung wäre also die komplette oberseitige Fläche 24 des Lichtleitelements 18 mit sichtbarem Licht beleuchtet.

Figur 4 zeigt schematisch die Darstellung eines ebenfalls einteilig ausgestalteten Lichtleitelements 18 an dessen dem Sender 12, dem Empfänger 14 und dem Signalelement 16 zugewandten unterseitigen Fläche 30 drei Säulen 28 mit rundem Querschnitt ausgebildet sind. Jeweils eine der Säulen 28 ist dem Sender 12, dem Empfänger 14 und dem Signalelement 16 zugeordnet. Dabei stellen die Säulen 28 ein Mittel zur optischen Strahlführung für Sender 12, Empfänger 14 und Signalelement 16 dar. Die Säulen 28 und das Lichtleitelement 18 können aus einem Teil gebildet sein. Die Säulen 28 können aber auch auf die unterseitige Fläche 30 des Lichtleitelements 18 aufgebracht sein. Weiterhin sind Sende- 20 und Empfangskanal 22 sowie der Lichtkegel 44 angedeutet.

Figur 5 zeigt ein drittes Ausführungsbeispiel der vorliegenden Erfindung. Hierbei wird das optische Mittel zur Strahlführung für Sender 12, Empfänger 14 und Signalelement 16 dadurch gebildet, dass Sender 12, Empfänger 14 und Signalelement 16 mit unterschiedlichem Abstand zum Lichtleitelement 18 auf der Platine 42 angeordnet sind. Durch den unterschiedlichen Abstand von Sender 12 und Empfänger 14 zum Signalelement 18 gegenüber dem Abstand des Signalelements 16 zum Signalelement 18, wie in Figur 5 dargestellt, wird erreicht, dass die Ausbreitungskeule der jeweils ausgesendeten Strahlung unterschiedlich breit ist. Auf diese Art und Weise kann beispielsweise ein schmaler Sendekanal 20 für Infrarotstrahlung und damit auch ein schmaler Empfangskanal 22 eingestellt werden, wodurch beide Kanäle 20, 22 von einander entkoppelt sind. Ein weiter vom Lichtleitelement 18 beabstandetes Signalelement 16 ergibt eine im Durchmesser größere Abstrahlkeule für das sichtbare Licht, so dass beispielsweise die ganze obere Fläche 24 beleuchtet wird.

Für jede Ausführungsform ist eine Überlagerung 26 von Sende- 20 und Empfangskanal 22 insoweit geeignet als der Anteil der Fläche der Überlagerung 26 zwischen 0 % bis maximal 40 % der oberseitigen Fläche 24 des Lichtleitelements 18 beträgt. In einer bevorzugten Ausgestaltung ist der Anteil der Fläche des Lichtleitelements 18 auf dem eine Überlagerung 26 des Sende- 20 und Empfangskanals 22 auftritt zwischen 0 % bis maximal 20 %. Optimalerweise beschränkt sich der Anteil der Fläche des Lichtleitelements 18, in dem eine Überlagerung 26 stattfindet, zwischen 0 % bis maximal 10 %.

Sender 12, Empfänger 14 und Signalelement 16 sind bevorzugt SMD-Bauteile, die auf einer Platine 42 angebracht sind. Bevorzugt handelt es sich bei dem Signalelement 16 um eine LED. Bedieneinrichtungen mit derartigen Tastschaltern 10 sind für alle elektronischen Geräte geeignet, bevorzugt jedoch Hausgeräte.

## Patentansprüche

1. Berührungsempfindlicher Tastschalter (10), mit einem Infrarot-Strahlung aussendenden Sender (12) und einem Infrarot-Strahlung empfangenden Empfänger (14), und mit wenigstens einem sichtbares Licht aussenden Signalelement (16), wobei Sender (12), Empfänger (14) und Signalelement (16) in ein einziges Lichtleitelement (18) einstrahlen,
**dadurch gekennzeichnet,**
**dass** infolge optischer Strahlführung eine Trennung des Sende- (20) und des Empfangskanals (22) im Lichtleitelement (18) derart erfolgt, dass sich an der dem Sender (12) und dem Empfänger (14) abgewandten oberseitigen Fläche (24) des Lichtleitelements (18) nur auf einem geringen Anteil der Fläche eine Überlagerung (26) des vom Sender (12) bestrahlbaren und des vom Empfänger (14) detektierbaren Bereichs ergibt.

2. Tastschalter nach Anspruch 1,
**dadurch gekennzeichnet,**
**dass** das Mittel zur optischen Strahlführung für Sender (12), Empfänger (14) und Signalelement (16) jeweils ein runde oder eckige Säule (28) ist, die an der dem Sender (12), Empfänger (14) und Signalelement (16) zugewandten unterseitigen Fläche (30) des Lichtleitelements (18) ausgebildet ist.

3. Tastschalter nach Anspruch 1 oder 2,
**dadurch gekennzeichnet,**
**dass** das Mittel zur optischen Strahlführung im Lichtleitelement (18) integriert ist.

4. Tastschalter nach Anspruch 3,
**dadurch gekennzeichnet,**
**dass** das Mittel zur optischen Strahlführung im Lichtleitelement (18) durch eine im Lichtleitelement (18) ringförmig um die Einkoppelfläche des Signalelements (16) verlaufende Nut (32) oder durch eine gerade oder gebogen verlaufene Nut (46) zwischen den Einkoppelflächen von Sender (12) und Signalelement (16) sowie durch eine gerade oder gebogen verlaufene Nut (46) zwischen den Einkoppelflächen von Signalelement (16) und Empfänger (14) gebildet ist.

5. Tastschalter nach Anspruch 4,
**dadurch gekennzeichnet,**
**dass** die von der Mittelsenkrechten (34) des Lichtleitelements (18) abgewandte Seite (36) der Nut (32, 46) zur Mittelsenkrechten (34) hin geneigt verläuft.

6. Tastschalter nach Anspruch 4 oder 5,
**dadurch gekennzeichnet,**
**dass** die der Mittelsenkrechten (34) des Lichtleitelements (18) zugewandte Seite (38) der Nut (32, 46) von der Mittelsenkrechten (34) weg geneigt verläuft.

7. Tastschalter nach Anspruch 1,
**dadurch gekennzeichnet,**
**dass** die optische Strahlführung außerhalb des Lichtleitelements (18) durch eine Anordnung von Sender (12), Empfänger (14) und Signalelement (16) mit unterschiedlichem Abstand zum Lichtleitelement (18) erfolgt.

8. Tastschalter nach einem der vorhergehenden Ansprüche,
**dadurch gekennzeichnet,**
**dass** das Lichtleitelement (18) einen eckigen oder einen runden Querschnitt aufweist und zwischen der unterseitigen (30) und der oberseitigen (24) Fläche keilförmig oder konisch verläuft.

9. Tastschalter nach einem der vorhergehenden Ansprüche,
**dadurch gekennzeichnet,**
**dass** der Anteil der Fläche des Lichtleitelements (18), auf dem die Überlagerung (26) des vom Sender (12) bestrahlbaren und des vom Empfänger (14) detektierbaren Bereichs möglich ist, zwischen 0 bis maximal 40 % beträgt, bevorzugt zwischen 0 bis maximal 20 % liegt.

10. Bedieneinrichtung für ein Haushaltsgerät mit wenigstens einem berührungsempfindlichen Tastschalter (10) nach einem der Ansprüche 1 bis 9.
